(19) Europäisches Patentamt
European Patent Office
Office européen des brevets

(11) EP 1 302 496 A1

(12) EUROPEAN PATENT APPLICATION
published in accordance with Art. 158(3) EPC

(43) Date of publication:
**16.04.2003 Bulletin 2003/16**

(21) Application number: **01945616.9**

(22) Date of filing: **27.06.2001**

(51) Int Cl.7: **C08G 59/20**, C08G 59/68, C09J 163/00, C09J 7/02, H05K 3/38, G03F 7/027

(86) International application number:
**PCT/JP01/05483**

(87) International publication number:
**WO 02/000756 (03.01.2002 Gazette 2002/01)**

(84) Designated Contracting States:
**BE DE FR GB IT NL**

(30) Priority: **28.06.2000 JP 2000194270**
**16.11.2000 JP 2000349246**
**16.02.2001 JP 2001039949**
**08.05.2001 JP 2001137083**
**31.05.2001 JP 2001164072**
**31.05.2001 JP 2001164073**

(71) Applicant: **Sumitomo Chemical Company, Limited**
**Osaka-shi Osaka 541-8550 (JP)**

(72) Inventors:
- **IYAMA, Hironobu**
  **Takatsuki-shi, Osaka 569-0066 (JP)**
- **HASEGAWA, Toshiyuki**
  **Nara-shi, Nara 631-0846 (JP)**
- **NAITOH, Shigeki**
  **Suita-shi, Osaka 565-0824 (JP)**

(74) Representative: **VOSSIUS & PARTNER**
**Siebertstrasse 4**
**81675 München (DE)**

# (54) INSULATING RESIN COMPOSITION, ADHESIVE RESIN COMPOSITION AND ADHESIVE SHEETING

(57) A resin composition for insulation material adhesive having excellent solder heat resistance comprising components (A) a copolymer comprising a vinyl group-containing monomer unit [a] and an epoxy group-containing monomer unit [b], and (B) a polymerization initiator;
a resin composition for adhesive adhesive having excellent solder heat resistance comprising components (A) a copolymer comprising a vinyl group-containing monomer unit [a] and an epoxy group-containing monomer unit [b], and (B') a cation polymerization initiator, wherein the composition has a melt viscosity of from 50 to 1000 Pa · s at a temperature of 180°C and a shearing speed of $1.2 \times 10^2$ $sec^{-1}$; and
an easy-peelable adhesion sheet comprising [I] an adhesion resin layer containing components (A) a copolymer comprising a vinyl group-containing monomer unit [a] and an epoxy group-containing monomer unit [b], and (B) a polymerization initiator and [II] a supporting substrate layer, wherein the layer [I] is laminated on the layer [II] and the surface of the layer [II] in contact with the layer [I] has a contact angle with water of 75° or more.

EP 1 302 496 A1

## Description

Field of the Invention

The present invention relates to a resin composition for insulation material comprising an epoxy group-containing olefin-based copolymer and a polymerization initiator, an insulation material obtained by hardening said composition, and a resin composition for adhesive and an adhesive obtained by photo-hardening said composition.
Further, the present invention relates an adhesion sheet obtained by laminating an adhesion resin layer containing such an epoxy group-containing olefin-based copolymer and a polymerization initiator and a supporting substrate layer excellent in releasability.

Background Art

An insulating solder resist is coated on the surface of a printed wiring board for protecting a conductor circuit exposed on the surface from the outside environments and for preventing solder from adhering to a conductor circuit on parts requiring no solder. A through hole (via) is provided through the coated solder resist and a solder in the form of sphere or projection is placed on the pore for mounting an electronic part such as an IC tip and the like, and after mounting an electronic part, the electronic part is soldered to a printed wiring board by solder reflow and the like.
Recently, as a method of providing a via, laser via formation methods using laser have been proposed (for example, WO 00/15015), and as a specific solder resist used in this formation method, a photosensitive material prepared by modifying an epoxy resin with acryl has been proposed. However, when the present inventors used this material as a solder resist, crack occurred in solder reflow, clarifying that solder heat resistance was not sufficient.
Under such conditions, the present inventors have intensively studied to find an insulation material excellent in solder heat resistance in solder reflow, and resultantly found that an insulation material obtained hardening a resin composition containing a copolymer composed of an epoxy group-containing monomer unit and a vinyl group-containing monomer unit as the main components, and a polymerization initiator is excellent in solder heat resistance and excellent in insulation and can be used in a solder resist, an interlaminar insulation material or a resin for copper foil with resin.
The resin composition for insulation material of the present invention and the insulation material obtained by hardening the composition were thus completed.
Further, recently, in the electronic and electric field, adhesives are utilized widely in semiconductor sealing materials, electronic part sealing materials for solar battery, EL (electro luminescence) lamp and the like, die bonding sheets for adhering an integrated circuit and a substrate, and the like. For the electric and electronic adhesives, heat resistance in solder bonding (so-called, solder heat resistance) is essentially required.
Japanese Patent Application Laid-Open (JP-A) No. 11-140414 discloses that a resin composition comprising an epoxy group-containing olefin-based copolymer and a cation polymerization initiator can be utilized as an adhesive and this composition is excellent in heat resistance.
However, when present inventors applied the resin composition described in the above-mentioned publication on a printed wiring board and hardened the composition and immersed the resulted printed wiring board in a solder bath of 260°C, the hardened substance, namely, and adhesive layer peeled from the printed wiring board, clarifying that further excellent solder heat resistance is necessary for use of this resin composition as an adhesive for electric and electronic parts.
For solving such problems, the present inventors have intensively studied a resin composition comprising an epoxy group-containing olefin-based copolymer and a cation polymerization initiator, and resultantly found that when a resin composition obtained by using a cation polymerization initiator has specific melt viscosity, the composition gives an adhesive having excellent solder heat resistance.
The resin composition for adhesive of the present invention and the adhesive obtained by photo-hardening this composition were thus completed.
Furthermore, recently, in the electronic and electric field, adhesion sheets are frequently used from the standpoints of improvement in productivity and simplification of processes. Specifically exemplified are laminated films for protecting the surface of a semiconductor wafer in a semiconductor package production process, dry film type solder resists, die bonding sheets for adhering an integrated circuit and a substrate, dry film type interlaminar insulation materials, and the like.
Such adhesion sheets for electric and electronic parts have a film-like form obtained by laminating an adhesive resin on a supporting substrate layer called separator made of polyethylene terephthalate, and as the specific method of using such sheets, there are known, for example, a method in which an adhesion resin layer is pasted and adhered on an adhesion body such as an electric and electronic part and the like, a supporting substrate layer is peeled, then the adhesion resin layer is used as a protective layer, a method in which after peeling a supporting substrate layer,

another adhesion body is further laminated, and used as an adhesive, and other methods.

On the other hand, resin compositions comprising an epoxy group-containing olefin-based copolymer and a polymerization initiator are described in the above-mentioned JP-A No. 11-140414 and Japanese Patent Application Publication (JP-B) No. 55-13908 and JP-A Nos. 11-140414 and 2000-17242, and the like, and it is also disclosed that an adhesive obtained by hardening the composition is excellent in solvent resistance and heat resistance.

The present inventors have investigated an adhesion sheet obtained by laminating an adhesion resin layer made of the adhesive resin composition described in the above-mentioned publications and a supporting substrate layer made of polyethylene terephthalate, and clarified that peeling between the adhesion resin layer and the supporting substrate layer is difficult.

Under such conditions, the present inventors have intensively studied an adhesion sheet obtained by laminating an adhesion resin layer and a supporting substrate layer, and resultantly found that an adhesion sheet combining a specific resin composition and a supporting substrate sheet having a specific surface property can solve such a subject, leading to completion of the adhesion sheet of the present invention.

## SUMMARY OF THE INVENTION

Namely, a first object of the present invention is to provide a resin composition for insulation material comprising the following components (A) and (B) and an insulation material obtained by hardening said composition.

(A) a copolymer comprising a vinyl group-containing monomer unit [a] and an epoxy group-containing monomer unit [b]
(B) a polymerization initiator

Also, the present invention provides a resin composition for adhesive comprising the above-mentioned component (A) and (B') a cation polymerization initiator component wherein the composition has a melt viscosity of from 50 to 1000 Pa · s at a temperature of 180°C and a shearing speed of $1.2\times10^2$ $sec^{-1}$.

Further, the present invention provides an adhesion sheet comprising [I] an adhesion resin layer composed a resin composition containing the above-mentioned components (A) and (B) and [II] a supporting substrate layer, wherein the layer [I] is laminated on the layer [II] and the surface of the layer [II] in contact with the layer [I] has a contact angle with water of 75° or more.

## DETAILED DESCRIPTION OF THE PREFERRED EMBODIMENTS

The component (A) in the resin composition used in the present invention is a copolymer containing a vinyl group-containing monomer unit [a] and an epoxy group-containing monomer unit [b] as the main component. An unsaturated ester compound unit [c] and the like may also be contained as a monomer unit (polymerization unit) of this copolymer.

The content of the epoxy group-containing monomer unit [b] in the component (A) is usually from about 1 to 150 parts by weight, preferably from about 1 to 50 parts by weight, more preferably from about 5 to 50 parts by weight based on 100 parts by weight of the vinyl group-containing monomer unit [a].

When the unsaturated ester compound unit [c] is contained in the component (A), the content of the unit [c] is usually about 250 parts by weight or less, particularly suitably from about 0 to 60 parts by weight, more preferably from about 0 to 50 parts by weight based on 100 parts by weight of the vinyl group-containing monomer unit [a].

The vinyl group-containing monomer unit [a] is a polymerization unit derived from a vinyl compound not containing an epoxy group and ester group (hereinafter, referred to as vinyl-containing compound). Here, specifically listed as the vinyl-containing compound are ethylene; α-olefins such as propylene, 1-butene, 4-methyl-1-pentene, 1-hexene, 1-heptene, 1-octene, 1-nonene, 1-decene and the like; aromatic vinyls such as styrene, α-methylstyrene, divinylbenzene and the like; conjugated diene compounds such as butadiene, isoprene and the like; acrylonitrile; vinyl chloride and the like. Particularly, vinyl compounds containing one vinyl group are preferable.

As the vinyl group-containing monomer unit [a], these vinyl compounds may be used singly or in combination of two or more.

When the component (A) is a block copolymer or graft copolymer and the like, the component (A) contains a polymer or copolymer composed of a vinyl group-containing monomer unit [a]. As such a polymer or copolymer, suitable are polyethylene, polypropylene, polymers obtained by copolymerizing ethylene and propylene.

The epoxy group-containing monomer unit [b] is a monomer unit derived from a compound containing an epoxy group and copolymerizable with a vinyl group-containing monomer unit [a] or its polymer (hereinafter, referred to as epoxy group-containing compound). As the specific example of the epoxy group-containing compound, alkenyl compounds containing an epoxy group of the following general formula (1):

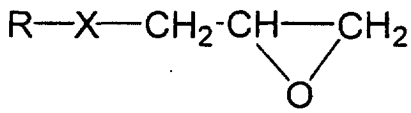

(1)

wherein R represents an alkenyl group having 2 to 18 carbon atoms, and X represents a carbonyloxy group, methyleneoxy group or phenyleneoxy group, and the like are listed.

Particularly, unsaturated glycidyl carboxylates such as glycidyl acrylate, glycidyl methacrylate, glycidyl itaconate and the like and unsaturated glycidyl ethers such as allyl glycidyl ether, methaallyl glycidyl ether, styrene-p-glycidyl ether and the like are preferable, and among them, glycidyl acrylate, glycidyl methacrylate and the like are suitable.

The unsaturated ester compound unit [c] is a polymerization unit derived from unsaturated ester compounds other than the above-mentioned unsaturated glycidyl carboxylates (hereinafter, simply referred to unsaturated ester compound). Specific examples of the unsaturated ester compound include saturated vinyl carboxylates such as vinyl acetate, vinyl propionate, vinyl butyrate and the like, unsaturated alkyl carboxylates such as methyl acrylate, ethyl acrylate, butyl acrylate, methyl methacry'late, ethyl methacrylate, butyl methacrylate and the like. Particularly, vinyl acetate, methyl acrylate, ethyl acrylate, methyl methacrylate and the like are suitable.

The component (A) in the present invention is a block copolymer, graft copolymer, random copolymer, alternating copolymer or the like of monomer units constituting the component (A).

Specific exemples are copolymers obtained by grafting a polymer composed of an epoxy group-containing monomer unit [b] to a propylene-ethylene block copolymer (block copolymer composed of vinyl group-containing monomer unit [a]) described in Japanese Patent No. 2632980, copolymers obtained by grafting an unsaturated ester compound unit [c] to a copolymer of an ethylene-epoxy group-containing monomer unit (copolymer composed of [a] and [b]) described in Japanese Patent No. 2600248, copolymers obtained by grafting an acrylonitrile-styrene copolymer (copolymer composed of [a]) to a copolymer composed of an epoxy group-containing monomer unit [b] described in JP-B No. 6-51767, and the like.

As the method of producing the component (A), there are listed, for example, a method in which a vinyl-containing compound, an epoxy group-containing compound, further, if necessary, a monomer unit such as an unsaturated ester compound and the like are copolymerized in the presence of a radical generating agent under a pressure of about $5\times10^7$ to $4\times10^8$ Pa (500 to 4000 atm) at a temperature of about 100 to 300°C in the presence of or absence of a suitable solvent and chain transfer agent, a method in which an epoxy group-containing compound, further, if necessary, an unsaturated ester compound and the like are added to a polymer obtained by polymerizing ethylene and/or propylene, and the mixture is mixed with a radical generating agent, and they are subjected to melt graft copolymerization in an extruder, and the like.

The melt viscosity of the component (A) is usually from about 50 to 1000 Pa · s, preferably from about 80 to 900 Pa · s, particularly preferably from about 200 to 800 Pa · s at a temperature of 180°C and a shearing speed of 1.2 $\times10^2$ $sec^{-1}$. The melt viscosity in the present invention is a value measured according to JIS K 7199.

Here, as the copolymer containing monomer units [a] and [b], commercially available copolymers such as, for example, "Bondfast (trade name, manufactured by Sumitomo Chemical Co., Ltd.)", "Recspar (trade name, manufactured by Nippon Polyolefin K.K.)", "LOTADER (trade name, manufactured by Ato Fina)" series and the like may be used.

For allowing the component (A) to have given melt viscosity, there are listed, for example, a method in which the molecular weight of the component (A) is controlled by a know method, a method in which the melt viscosity of two or more copolymers containing a vinyl group-containing monomer unit [a] and an epoxy group-containing monomer unit [b] is measured and each mixing ratio for giving desired melt viscosity is calculated, and mixing is effected according to the calculation results, and other methods.

Thus obtain number-average molecular weight of the component (A) is usually from about 10000 to 100000 in terms of polystyrene measured according to gel permeation chromatography (GPC). Its melt index (JIS K6760) is usually from about 0.5 to 600 g/10 minutes, particularly, preferably from about 2 to 50 g/10 minutes.

The component (B) in the present invention is a compound capable of initiating polymerization of an epoxy group and/or vinyl group contained in the component (A), and specifically listed are cation polymerization initoators; anion polymerization initiators such as imidazole-based compounds, carbamate-based compounds and the like; photo-radical polymerization initiators; heat radical polymerization initiators and the like, and of them, cation polymerization initiators and photo-radical polymerization initiators are preferable from the standpoint of hardening speed, and particularly, photo-radical polymerization initiators are suitable.

Particularly, in the adhesive of the present invention, (B') a cation polymerization initiator is used.

As the cation polymerization initiators for the component (B) or (B'), there are listed onium salts constituted of at least one cation selected from the group consisting of aromatic sulfonium, aromatic iodonium, aromatic diazonium,

aromatic ammonium, η $^5$-cyclopentadienyl-η$^6$-cumenyl-Fe salts and the like and at least one anion selected from the group consisting of $BF_4^-$, $PF_6^-$, $SbF_6^-$ and an anion of the following general formula (2):

$$[BY_4^-] \quad (2)$$

wherein Y represents a phenyl group having two or more substitutions of fluorine or trifluoromethyl group, for example.

Examples of the aromatic sulfonium salt type cation polymerization initiator include bis[4-(diphenylsulfonio) phenyl]sulfide bishexafluorophosphate, bis[4-(diphenylsulfonio)phenyl]sulfide bishexafluoroantimonate, bis[4-(diphenylsulfonio)phenyl]sulfide bistetrafluoroborate, bis[4-(diphenylsulfonio)phenyl]sulfide tetrakis (pentafluorophenyl)borate, (2-ethoxy-1-methyl-2-oxoethyl)methyl-2-naphtalenylsulfo nium hexafluorophosphate, (2-ethoxy-l-methyl-2-oxoethyl)methyl-2-naphthalenylsulf onium hexafluoroantimonate, (2-ethoxy-1-methyl-2-oxoethyl)methyl-2-naphthalenylsulf onium tetrafluoroborate, (2-ethoxy-1-methyl-2-oxoethyl)methyl-2-naphthalenylsulf onium tetrakis(pentafluorophenyl)borate, diphenyl-4-(phenylthio)phenylsulfonium hexafluorophosphate, diphenyl-4-(phenylthio)phenylsulfonium hexafluoroantimonate, diphenyl-4-(phenylthio)phenylsulfonium tetrafluoroborate, diphenyl-4-(phenylthio)phenylsulfonium tetrakis(pentafluorophenyl)borate, triphenylsulfonium hexafluorophosphate, triphenylsulfonium hexafluoroantimonate, triphenylsulfonium tetrafluoroborate, triphenylsulfonium tetrakis(pentafluorophenyl)borate, bis[4-(di(4-(2-hydroxyethoxy))phenylsulphonio)phenyl]su lfide bishexafluorophosphate, bis[4-(di(4-(2-hydroxyethoxy)]phenylsulphonio)phenyl]su lfide bishexafluoroantimonate, bis[4-(di(4-(2-hydroxyethoxy))phenylsulphonio)phenyl]su lfide bistetrafluoroborate, bis[4-(di(4-(2-hydroxyethoxy))phenylsulphonio)phenyl]su lfide tetrakis(pentafluorophenyl)borate and the like.

Examples of the aromatic iodonium salt type cation polymerization initiator include diphenyliodonium hexafluorophosphate, diphenyliodonium hexafluoroantimonate, diphenyliodonium tetrafluoroborate, diphenyliodonium tetrakis(pentafluorophenyl)borate, bis(dodecylphenyl)iodonium hexafluorophosphate, bis(dodecylphenyl)iodonium hexafluoroantimonate, bis(dodecylphenyl)iodonium tetrafluoroborate, bis (dodecylphenyl)iodonium tetrakis(pentafluorophenyl)borate, 4-methylphenyl-4-(1-methylethyl)phenyliodonium hexafluorophosphate, 4-methylphenyl-4-(1-methylethyl)phenyliodonium hexafluoroantimonate, 4-methylphenyl-4-(1-methylethyl)phenyliodonium tetrafluoroborate, 4-methylphenyl-4-(1-methylethyl)phenyliodonium tetrakis(penfluorophenyl)borate and the like.

Examples of the aromatic diazonium salt type cation polymerization initiator include phenyldiazonium hexafluorophosphate, phenyldiazonium hexafluoroantimonate, phenyldiazonium tetrafluoroborate, phenyldiazonium tetrakis(pentafluorophenyl)borate and" the like.

Examples of the aromatic anmonium salt type cation polymerization initiator include 1-benzyl-2-cyanopyridinium hexafluorophosphate, 1-benzyl-2-cyanopyridinium hexafluoroantimonate, 1-benzyl-2-cyenopyridinium tetrafluoroborate, 1-benzyl-2-cyanopyridinium tetrakis(pentafluorophenyl)borate, 1-(naphthylmethyl)-2-cyanopyridinium hexafluorophosphate, 1-(naphthylmethyl)-2-cyanopyridnium hexafluoroantimonate, 1-(naphthylmethyl)-2-cyanopyridinium tetrafluoroborate, 1-(naphthylmethyl)-2-cyanopyridinium tetrakis(pantafluorophenyl)borate and the like.

Examples of the η$^5$-cyclopentadienyl-η$^6$-cumenyl-Fe salt type cation polymerization initiator include η $^5$-cyclopentadienyl-η$^6$-cumenyl-Fe (II) hexafluorophosphate, η$^5$-cyclopentadienyl-η$^6$-cumenyl-Fe (II) hexafluoroantimonate, η$^5$-cyclopentadienyl-η $^6$-cumenyl-Fe (II) tetrafluoroborate, η $^5$-cyclopentadienyl-η$^6$-cumenyl-Fe (II) tetrakis (pentafluorophenyl)borate and the like.

As the cation polymerization initiator, commercially available cation polymerization initiator may be used, and specific examples thereof include UVI-6990 (mixture of bis[4-(diphenylsulfonio)phenyl]sulfide bishexafluorophosphate and triphenylsulfonium hexafluorophosphate manufactured by Union Carbide), UVACURE 1591 (mixture of bis [4-(diphenylsulfonio)phenyl]sulfide bishexafluorophosphate and triphenylsulfonium hexafluorophosphate manufactured by Daicel UCB), UVI-6974 (mixture of bis[4-(diphenylsulfonio)phenyl]sulfide bishexafluoroantimonate and triphenylsulfonium hexafluoroantimonate manufactured by Union Carbide), SP-150
(bis[4-di(4-(2-hydroxyethoxy))phenylsulfonio)phenyl]sul fide bishexafluorophosphate manufactured by Asahi Denka Kogyo K.K.), SP-170 (bis[4-di(4-(2-hydroxyethoxy))phenylsulfonio)phenyl]sul fide bishexafluoroantimonate manufactured by Asahi Denka Kogyo K.K.), CI-2855 (manufactured by Nippon Soda Co., Ltd.), Sun Aid SI-60L (manufactured by Sanshin Kagaku K.K.), Sun Aid SI-80L (manufactured by Sanshin Kagaku K.K.), Sun Aid SI-100L (manufactured by Sanshin Kagaku K.K.), FC-508 (manufactured by 3M), FC-512 (manufactured by 3M), Irgacure 261 (2,4-cyclopentadien-1-yl)[(1-methylethyl)benzene]-Fe (II) hexafluorophosphate) manufactured by Chiba Specialty Chemicals), RHODORSIL 2074 (4-methylphenyl-4-(1-methylethyl)phenyliodonium tetrakis(pentafluorophenyl)borate manufactured by Rhône Poulenc) and the like.

Examples of the photo-radical polymerization initiator include 2,2-dimethoxy-1,2-diphenylethane-1-one, 1-hydroxy-1-cyclohexylphenylketone, 2-hydroxy-2-methyl-1-phenylpropane-1-one, 1-[4-(2-hydroxyethoxy)phenyl]-2-hydroxy-2-methylpropane -1-one, 2-methyl-1-[4-(methylthio)phenyl]-2-morpholinopropane-1 -one, 2-benzyl-2-dimethylamino-1-(4-morpholinophenyl)-butane-1-one, bis(2,6-dimethoxybenzoyl)-2,4,4-trimethylpentylphosphin eoxide, bis (2,6-dimethoxybenzoyl)-phenylphosphineoxide and the like.

As the polymerization initiator (B) in the resin composition for insulation material or the adhesion sheet of the present invention, two or more different polymerization initiators may be used. Namely, as the component (B), two or more different polymerization initiators selected from cation polymerization initiators, heat cation polymerization initiators, photo-radical polymerization initiators and heat radical polymerization initiators may be used together.

As the polymerization initiator (B') in the resin composition for adhesive of the present invention, cation polymerization initiators and one or more other polymerization initiators may be used together.

When a cation polymerization initiator is used, an onium salt in which the anion is $PF_6^-$ is preferable, and particularly, aromatic sulfonium hexafluorophosphate is suitable.

The resin composition for insulation material in the present invention is a resin composition containing the component (A) and the component (B).

When used as a solder resist and the like, the resin composition for insulation material of the present invention may contain, for example, coloring matters, pigments and the like such as phthalocyanine green, carbon black and the like, to mask a conductor circuit on the surface of a printed wiring board.

Further, additives such as sensitizers, compounding agents and the like may be contained, if necessary.

As the sensitizer, for example, pyrene, perylene, 2,4-diethylthioxanthone, phenothiazine and the like are listed. The content of the sensitizer is usually from about 0 to 10 parts by weight based on 100 parts by weight of the component (A).

As the compounding agent added to the resin composition for insulation material, there are listed reaction diluents, thermoplastic resins, thermo-setting resins, heat stabilizers, antioxidants, weather resistant agents, light stabilizers, nucleating agents, lubricants, releasing agents, flame retardants, thickening agents, leveling agents, antifoaming agents, close adhesion imparting agents, antistatic agents, fillers, reinforcing agents such as glass fiber, and the like.

Regarding the weight ratio of the component (A) and the component (B) in the resin composition for insulation material in the present invention, the amount of the component (B) is usually about 0.3 to 10 parts, particularly preferably about 0.3 to 5 parts based on 100 parts of the component (A). When the amount of the component (B) is more 0.3 part, there is a preferable tendency of increase in solder heat resistance, and when less than 10 parts, there is a preferable tendency that the amount of an unreacted polymerization initiator in the resulting insulation material decreases.

The melt viscosity of the resin composition for insulation material is usually from about 50 to 1000 Pa · s, preferably from about 80 to 900 Pa · s, particularly preferably from about 200 to 800 Pa · s, at a temperature of 180°C and a shearing speed of $1.2\times10^2$ $sec^{-1}$. When the melt viscosity of the component (A) is 50 Pa · s or more, a tendency occurs of increase in the solder heat resistance of the resulting insulation material, and when 1000 Pa · s or less, a tendency occurs of increase in the flowability of the resin composition.

As the method of controlling the melt viscosity of a resin composition at given value, there is listed, for example, a method of controlling the melt viscosity of the component at about the same value as given melt viscosity.

As the method of producing the resin composition for insulation material, there are listed, for example, a method of compounding the components (A), (B), additives and the like and melt-kneading them by an extruder and the like, a method of compounding the components (A), (B), additives and the like and blending them by a Henschel mixer and the like, etc..

As the method of film formation of the resin composition for insulation material, there are listed a method in which the resin composition is extruded by a extruder, a method of palletizing the resin composition by a kneader, then, extruding it, and the like, and specifically exemplified are a T-die method, inflation method and the like. Further, it may be possible that the resin composition is dissolved in a solvent, and then the solution is formed to film by casting method.

The thickness of the above-mentioned film is usually from about 10 to 500 μm.

An insulation material can be obtained by hardening thus obtained resin composition for insulation material. When hardening is thermal hardening, its hardening conditions are usually so that components (B) such as a heat cation polymerization initiator, heat radical initiator and the like can be activated, and the specific hardening conditions include a temperature of about 90 to 250°C and a time of about 5 seconds to 2 hours, preferably a temperature of about 150 to 210°C and a time of about 5 minutes to 1 hour. From the standpoint of maintaining surface smoothness, an insulation material obtained by thermal hardening under pressure by a press and the like is preferable.

When hardening is photo-hardening, its hardening conditions are usually so that components (B) such as a cation polymerization initiator, photo-radical initiator and the like can be activated. Specific hardening conditions thereof in producing a solder resist include

(A) a method in which a resin composition for insulation material is made into a film which is coated on a printed wiring board while heating, then, hardened with light,

(B) a method in which a resin composition for insulation material is coated on a printed wiring board by a hot melt

applicator, hot melt coater and the like while melting with heat, subsequently, hardened with light,

(C) a method in which a thermoplastic resin such as polypropylene, polyethylene terephthalate, polytetrafluoroethylene, ethylene·tetrafluoroethylene copolymer and the like and a resin composition for insulation material are laminated to make film of two layers, the surface of the resin composition layer and the surface of a printed wiring board are pasted and hardened with light, then, the layer of the thermoplastic resin is peeled,

(D) a method in which a resin composition for insulation material is made into film and hardened with light, then, coated on a printed wiring board while heating, and the like.

Among methods of producing a solder resist obtained by hardening with light, methods of coating a resin composition for insulation material on a printed wiring board before hardening with light such as the above-mentioned methods (A) to (C) are preferable, and particularly, the method (A) is preferable. In a method of hardening a resin composition for insulation material with light, then, coating it on a printed wiring board such as the method (E) and the like, it is desirable that the light-hardened composition is quickly coated on a printed wiring board.

As the beam for light-hardening a resin composition for insulation material, beams capable of activating components (B) such as a cation polymerization initiator, photo-radical initiator and the like such as ultraviolet ray, visible beam, infrared light, electron beam and the like are listed. The dose of beam is usually from about 0.1 to 10000 $mJ/cm^2$.

As the insulation material of the present invention, insulation materials obtained by further thermally hardening, at a temperature of about 110 to 250°C, particularly preferably of about 150 to 210°C, those obtained by light-hardening, are suitable, for improving the solder heat resistance after moisture absorption of the insulation material.

Thus obtained insulation material can be used as an interlaminar insulation material performing insulation while ensuring the adhesion of a conductor circuit layer in laminating a solder resist and a conductor circuit layer, or as an insulation material for electric and electronic parts such as a resin for copper foil with resin having a copper foil layer capable of forming a conductor circuit.

The solder resist of the present invention is usually subjected to via formation by laser. As the laser used, for example, a carbon dioxide gas laser and the like are listed. Laser usually has an energy of about 20 to 40 mJ, and performed at a short pulse of about $10^{-4}$ to $10^{-8}$ seconds. The shot number of pulse necessary for via formation is usually from about 5 to 100.

The insulation material of the present invention is suitable as a solder resist using a laser via formation method and the like, because of excellent solder heat resistance. Further, the resin composition for insulation material of the present invention can be used also in semiconductor package materials, printed wiring boards, interlaminar insulation materials, copper foil with resin, and the like, since the composition gives an insulation material having an excellent insulation property.

The resin composition for adhesive of the present invention is a resin composition containing the component (A) and the component (B') and having a melt viscosity of 50 to 1000 Pa · s, preferably about 80 to 900 Pa · s, particularly preferably about 200 to 800 Pa · s, at a temperature of 180°C and a shearing speed of $1.2\times10^2$ $sec^{-1}$.

When the melt viscosity of the resin composition for adhesive is 50 Pa·s or more, a tendency occurs of increase in the solder heat resistance of the resulting adhesive, and when 1000 Pa·s or less, a tendency occurs of increase in the flowability of the resin composition.

For allowing the resin composition for adhesive of the present invention to have given melt viscosity, it may be usually permissible that the melt viscosity of the component (A) is controlled to approximately the same value as the given melt viscosity of the resin composition.

Regarding the weight ratio of the component (A) and the component (B') in the resin composition for adhesive in the present invention, the amount of the component (B') is usually about 0.3 to 10 parts, particularly preferably about 0.3 to 5 parts based on 100 parts of the component (A) . When the amount of the component (B) is over 0.3 parts, there is a preferable tendency of increase in solder heat resistance, and when less than 10 parts, there is a preferable tendency that the amount of an unreacted polymerization initiator in the resulting insulation material decreases.

The resin composition for adhesive of the present invention may contain, for example, coloring matters, pigments and the like such as phthalocyanine green, carbon black and the like. Further, additives such as a sensitizer, compounding agent and the like may also be contained, if necessary.

Here, as the sensitizer and compounding agent, the same compounds as used in the resin composition for insulation material of the present invention can be used. The compounding amount is also the same as in the composition of the present invention.

As the method of producing the resin composition for adhesive of the present invention, there are listed, for example, a method of compounding the components (A), (B'), additives and the like and melt-kneading them by an extruder and the like, a method of compounding the components (A), (B'), additives and the like and blending them by a Henschel mixer and the like, etc..

The adhesive of the present invention which is hardened with light contains thus obtained resin composition for adhesive as an effective ingredient. For form of the adhesive, for example, forms of pellet, film and the like are listed.

Specific methods of producing an adhesive include

(A) a method in which the resin composition is made into film which is coated on an electric and electronic part while heating, then, hardened with light,
(B) a method in which the resin composition is coated on an electric and electronic part by a hot melt applicator, hot melt coater and the like while melting with heat, subsequently, hardened with light,
(C) a method in which a thermoplastic resin such as polypropylene, polyethylene terephthalate, polytetrafluoroethylene, ethylene · tetrafluoroethylene copolymer and the like and the resin composition are laminated to make film of two layers, the surface of the resin composition layer and the surface of an electric and electronic part are pasted and hardened with light, then, the layer of the thermoplastic resin is peeled,
(D) a method in which the resin composition is made into film and hardened with light, then, coated on an electric and electronic part while heating, and the like. The resulted adhesive may be further heat-pressed by a press heated at about 110 to 250°C, preferably about 150 to 210°C, for improving an adhesive force.

Among methods of producing an adhesive, methods of coating a resin composition on an electric and electronic part before hardening with light such as the above-mentioned methods (A) to (C) are preferable, and particularly, the method (A) is preferable. In a method of hardening a resin composition with light, then, coating it on an electric and electronic part such as the method (E) and the like, it is desirable that coating is quickly effected after hardening with light.
As the method of film formation of the resin composition for adhesive, there are listed a method in which the resin composition is extruded by an extruder, a method of palletizing the resin composition by a kneader, then, extruding it, and the like, and specifically exemplified are a T-die method, inflation method, hot melt applicator method and the like. Further, it may also be permissible that the resin composition is dissolved in a solvent, and then the solution is formed to film by casting method.
The thickness of the above-mentioned film is usually from about 10 to 500 μm.
As the beam for light-hardening a resin composition for adhesive, beams capable of activating components (B) such as ultraviolet ray, visible beam, infrared light, electron beam and the like are listed. The dose of beam is usually from about 0.1 to 10000 mJ/$cm^2$.
As the electric and electronic part in which thus obtained adhesive is used, there are listed, for example, semiconductor sealing materials, electronic part sealing materials for solar battery, EL (electro luminescence) lamp, IC card, memory card and the like, die bonding sheets for adhering an integrated circuit and a substrate, and the like.
The resin composition for adhesive of the present invention can be used as a solder-resistant adhesive due to excellent solder heat resistance. Of them, the composition can be used in electric and electronic parts such as semiconductor sealing materials, electronic part sealing materials for solar battery, EL (electro luminescence) lamp, IC card, memory card and the like, die bonding sheets for adhering an integrated circuit and a substrate, and the like, due to excellent properties of the composition.
The adhesion sheet of the present invention has [I] an adhesion resin layer and [II] a supporting substrate layer of which surface in contact with the layer [I] has a contact angle with water of 75° or more, and the adhesion resin layer [I] is composed of the above-mentioned adhesive resin composition containing the components (A) and (B).
Regarding the weight ratio of the component (A) and the component (B) in the resin composition for adhesive, the amount of the component (B) is usually about 0.3 to 10 parts, particularly preferably about 0.3 to 5 parts based on 100 parts of the component (A). When the amount of the component (B) is over 0.3 parts, there is a preferable tendency of increase in solder heat resistance, and when less than 10 parts, there is a preferable tendency that the amount of an unreacted polymerization initiator in the resulting insulation material decreases.
The resin composition for adhesive may contain, for example, coloring matters, pigments and the like such as phthalocyanine green, carbon black and the like. Further, additives such as a sensitizer, compounding agent and the like may also be contained, if necessary.
Here, as the sensitizer and compounding agent, the same compounds as used in the resin composition for insulation material of the present invention can be used. The compounding amount is also the same as in the composition of the present invention.
As the method of producing the resin composition for adhesive, there are listed, for example, a method of compounding the components (A), (B), additives and the like and melt-kneading them by an extruder and the like, a method of compounding the components (A), (B), additives and the like and blending them by a Henschel mixer and the like, etc..
The supporting substrate layer [II] used in the adhesive sheet of the present invention has a surface in contact with the layer [I] having a contact angle with water of 75° or more, preferably of 80 to 120°.
Listed as specific materials of the supporting substrate layer [II] are, for example, water repellent resins such as polyolefins such as polytetrafluoroethylene, ethylene · tetrafluoroethylene copolymer, polypropylene, and the like;

those obtained by surface-treating the surface of a thermoplastic resin such as polyesters such as polyethylene terephthalate and the like, polyolesins and the like with a releasing agents such as silicon-based compounds such as polydimethylsiloxane, hardening type silicon resins, hardening type modified silicon resins and the like, fluorine-based compounds such as solvent-soluble fluoroolefin-based resins, fluorine-containing acrylate copolymers, fluoroalkylalkoxysilane, heptadecafluorodecyltrimethoxysilane, poly($\alpha,\alpha,\alpha',\alpha$ '-tetrafluoro-p-xylylene and the like, montanic acid-based wax, montanate-based wax, partially saponified montanate wax, oxidized or non-oxidized polyethylene-based wax, oxidized or non-oxidized polypropylene-based wax, paraffin-based wax and carnauba wax and the like.

Further, for improving releasability, an antistatic agent may also be contained in the material of the supporting substrate layer [II].

As the material of the supporting substrate layer [II], particularly, water-repellent resins, and thermoplastic resins having a surface treated with a silicon-based compound or a fluorine-based compound, and among others, from the standpoint of heat resistance, polytetrafluoroethylene and, polyethylene terephthalate surface-treated with a silicon-based compound or a fluorine-based compound, are suitable.

As the supporting substrate layer [II], for example, commercially available products such as nylon tape TOMBO 9001 (manufactured by Nichias Corp., polytetrafluoroethylene), Diafoil MRX (manufactured by Mitsubishi Chemical Polyester film, polyethylene terephthalate, silicon-based surface-treated product), MRA, MRF (manufactured by the same company), Purex G12 (manufactured by Teijin DuPont, polyethylene terephthalate, silicon-based surface-treated product), Emblet SC (manufactured by Unitika, Ltd., polyethylene terephthalate, silicon-based surface-treated product), Emblet FC (manufactured by Unitika, Ltd., polyethylene terephthalate, fluorine-based surface-treated product), Emblet FF (manufactured by Unitika, Ltd., polyethylene terephthalate, fluorine-based surface-treated product), and the like may also be used.

As the method of producing the adhesion sheet of the present invention obtained by laminating the adhesion resin layer [I] and the supporting substrate layer [II], there are listed, for example, (A) a method in which a resin composition for adhesive is extrusion-laminated on a supporting substrate layer [II] to form an adhesion resin layer [I]; (B) a method in which a resin composition for adhesive is applied on a supporting substrate layer [II] by a hot melt applicator to form an adhesion resin layer [I]; (C) a method in which an adhesion body, adhesion resin layer [I] and supporting substrate layer [II] are laminated sequentially and then heat-pressed; (D) a method in which a resin composition for adhesive is dissolved in a solvent and cast on a supporting substrate layer [II], and the like. Of them, the methods (A) to (C) are suitable.

Here, listed as the coating body are electric and electronic parts such as semiconductor sealing materials, electronic part sealing materials for solar battery, EL (electro luminescence) lamp, IC card, memory card and the like, die bonding sheets for adhering an integrated circuit and a substrate, and the like.

The thickness of the adhesion resin layer [I] and the supporting substrate layer [II] in the adhesion sheet of the present invention is usually from about 10 to 500 $\mu$ m, preferably from about 25 to 200 $\mu$m.

Thus obtained adhesion sheet is pasted on an adhesion body, then, the supporting substrate layer is peeled, and the adhesion resin layer is hardened, to give a laminate of the present invention. Further, it may also be permissible that another adhesion body is adheres on the adhesion resin layer from which the supporting substrate layer has been peeled, then, the adhesion resin layer is hardened.

Hardening is conducted by light-hardening, thermal hardening and the like.

As the beam for light-hardening, beams capable of activating components (B) such as a cation polymerization initiator, photo-radical initiator and the like such as ultraviolet ray, visible beam, infrared light, electron beam and the like are listed. The dose of beam is usually from about 0.1 to 10000 mJ/$cm^2$.

Thermal hardening conditions are usually so that components (B) such as a heat cation polymerization initiator, heat radical initiator and the like can be activated, and the specific hardening conditions include a temperature of about 90 to 200°C and a time of about 5 seconds to 2 hours, preferably a temperature of about 100 to 180°C and a time of about 5 minutes to 1 hour. From the standpoint of maintaining surface smoothness, it is preferable to conduct thermal hardening under pressure by a press and the like.

When a photo-cation polymerization initiator and/or photo-radical initiator is contained as the component (B), it may also be permissible that, after light-hardening, thermal hardening is further conducted.

The adhesion sheet of the present invention can be used as an adhesion sheet for coating a dry film type solder resist, a lamination film for surface protection of a semiconductor water in a semiconductor package production process, since when an adhesion resin layer excellent in solvent resistance and heat resistance is pasted to an adhesion body before easily peeling a supporting substrate layer and hardening the sheet, the adhesion resin layer and adhesion body show excellent adhesion.

Further, when an adhesion resin layer and an adhesion body are pasted and a supporting substrate layer is peeled and then pasting another adhesion body on the surface of the adhesion resin layer from which the supporting substrate layer has been peeled followed by hardening the sheet, the adhesion sheet of the present invention can be used as an adhesion sheet for electric and electronic parts and the like such as a die bonding sheet for adhering a dry

film type interlaminar insulation material integrated circuit excellent in adhesion and a substrate.

EXAMPLES

The following examples will illustrate the present invention in more detail below but do not limit the scope of the invention. Here, parts in the following examples are by weight unless otherwise stated.

<Component (A)>

The following copolymers were used as the component (A).

A1: ethylene · glycidyl methacrylate copolymer

(manufactured by Sumitomo Chemical Co., Ltd., Bondfast E, ethylene unit=100 parts, glycidyl methacrylate unit=13.6 parts, melt viscosity is 704 Pa · s)

A2: ethylene · glycidyl methacrylate · methyl acrylate copolymer

(manufactured by Sumitomo Chemical Co., Ltd., Bondfast 7M, ethylene unit=100 parts, glycidyl methacrylate unit=9.4 parts, methyl acrylate unit=46.9 parts)

A3: ethylene · glycidyl methacrylate·vinyl acetate copolymer

(manufactured by Sumitomo Chemical Co., Ltd., Bondfast 7B, ethylene unit=100 parts, glycidyl methacrylate unit=14.5 parts, vinyl acetate unit=46.9 parts)

A4: ethylene · glycidyl methacrylate copolymer

(manufactured by Sumitomo Chemical Co., Ltd., Bondfast CG5001, ethylene unit=100 parts, glycidyl methacrylate unit=22.0 parts, melt viscosity is 37 Pa · s)

A5: ethylene · glycidyl methacrylate copolymer

(manufactured by Sumitomo Chemical Co., Ltd., Bondfast 2C, ethylene unit=100 parts, glycidyl methacrylate unit=6.4 parts, melt viscosity is 633 Pa · s)
In the examples, the melt viscosity was measured according to the following method.

<Measurement of melt viscosity>

Using a capillary rheometer "Capillograph 1C" manufactured by Toyo Seiki Seisakusho K.K., melt viscosity was measured under conditions of a capillary diameter of 1 mm ϕ, capillary length of 40 mm, a barrel of 9.55 mm, a shearing speed of $1.2 \times 10^2$ $sec^{-1}$, and a temperature of 180°C.

<Component (B)>

The following cation polymerization initiators were used as the component (B) or (B').

B1: SP-150
(bis[4-(di(4-(2-hydroxyethoxy))phenylsulfonio)phenyl]su lfide bishexafluorophosphate, manufactured by Asahi Denka Co., Ltd.)
B2: UVACURE 1591 (mixture of bis[4-(diphenylsulfonio)phenyl]sulfide bishexafluorophosphate and triphenylsulfonium hexafluorophosphate, manufactured by Daicel UCB)
B3: UVI-6990 (mixture of bis[4-(diphenylsulfonio)phenyl]sulfide bishexafluorophosphate and triphenylsulfonium hexafluorophosphate manufactured by Union Carbide)

<Pigment (C)>

The following pigments were used.

C1: carbon black (manufactured by Mitsubishi Chemical Co., Ltd., Carbon Black MA 600)
C2: carbon black (manufactured by Cabot, BP 3700)

(Production Example 1 of resin composition for insulation material)

<Examples 1 to 8, Comparative Examples 1 to 2>

Into Laboplastomill R-100 manufactured by Toyo Seiki Seisakusho K.K. was added components (A) to (B) and pigment (C1) at ratios shown in Table 1, and melt-kneaded at 120°C for 10 minutes. The resulted resin compositions were subjected to press molding to obtain films having a thickness of about 100 μm and sheets having a thickness of 1 mm.

(Production Example 2 of resin composition for insulation material)

<Examples 9 to 11>

Using a homo-direction twin-screw extruder equipped with a liquid addition apparatus, 100 parts of the component (A) and 3 parts of the component (B) were melt-kneaded at a temperature of 140°C and a screw rotation of 200 rpm, to obtain pellets.. The resulted pellet was extruded through a T die to give a film of about 35 μm which was laminated to give a single layer film.

(Example 1)

<Method of light irradiation before heat press (BF)>

The film having a thickness of about 100 μm and a sheet having a thickness of 1 mm of the compositions for insulation material obtained in the above-mentioned Production Example 1 were irradiated at a dose of 400 mJ/$cm^2$ using an ultraviolet irradiation machine manufactured by Eye Graphics. Subsequently, the film having a thickness of 100 μm after irradiation with ultraviolet ray was heat-pressed on a laminate coated with copper on both surfaces: R-1705 (printed wiring board) manufactured by Matsushita Electric Works, Ltd. under conditions of 180°C and 0.5 MPa, to obtain a printed wiring board coated with a solder resist, and this wiring board was subjected to a solder heat resist test. Under the same irradiation conditions, only a sheet having a thickness of 1 mm was irradiated, and subjected, as it was, to a dynamic viscoelastocity test.

(Examples 2 to 11)

<Method of light irradiation after heat press (AF)>

The film of the composition for insulation material having a thickness of about 100 μm obtained in the above-mentioned Production Example 1 was heat-pressed on a laminate coated with copper on both surfaces: R-1705 (printed wiring board) manufactured by Matsushita Electric Works, Ltd. under conditions of 180°C, 0.5 MPa and 10 minutes. Subsequently, the laminate was irradiated at a dose of 400 mJ/$cm^2$ or 600 mJ/$cm^2$ using an ultraviolet irradiation machine manufactured by Eye Graphics, to obtain a printed wiring board coated with a solder resist. This wiring board was subjected to a solder heat resistance test. Under the same irradiation conditions, only a sheet having a thickness of 1 mm was irradiated, and subjected, as it was, to a dynamic viscoelastocity test.

(Comparative Example 1)

<Method without light irradiation>

The same procedure was conducted as in Example 1 except that irradiation with ultraviolet by an ultraviolet irradiation machine was not conducted. A printed wiring board coated with a solder resist was subjected to a solder heat resistance rest, and a sheet having a thickness of 1 mm was subjected to a dynamic viscoelastocity test.

(Comparative Example 2)

<Method of light irradiation after resin application (AF)>

Components A and B of an epoxy resin acryl-modified photo solder resist: SR-320 (manufactured by San Hayato K.K.) were mixed at a weight ratio of 7:3, and the resulted past was applied at a thickness of 3 mil on a printed wiring board using an applicator. After drying at 60°C for 10 minutes, then, the laminate was irradiated at a dose of 800 mJ/$cm^2$ using an ultraviolet irradiation machine manufactured by Eye Graphics, to obtain a printed wiring board coated with a solder resist. This wiring board was subjected to a solder heat resistance test. Due to insufficient hardening of the sheet having a thickness of 1 mm, a dynamic viscoelastocity test could not be carried out.

The solder heat resistance test, dynamic viscoelastocity test and insulation resistance test were conducted according to the following procedures, and the results are summarized in Table 1.

<Solder heat resistance test>

A printed wiring board coated with a solder resist was immersed in a solder bath of 260°C for 10 seconds using SOLDERABILITY TESTER EST-11 manufactured by Tabai Especk. This was determined as one cycle, and six cycles were repeated, then, the surface appearance was observed.

Evaluation was conducted according to the following criteria.

○: Film appearance shows no abnormality (peeling, swelling), and no solder submerging is manifested
×: Film appearance shows abnormality (peeling, swelling), and solder submerging is manifested

<Dynamic viscoelasticity test>

The storage elasticity (E') at 100°C and 220°C of a sheet having a 1 mm layer of a composition for insulation material were measured using DVA-220 manufactured by Aity Keisoku Seigyo K.K. under conditions of a frequency of 1 Hz and a dynamic strain of 0.1%, and log [ΔE'] was calculated according to the following formula.

$$\log [\Delta E'] = \log (\{E' \text{ at } 220°C\}/\{E' \text{ at } 100°C\})$$

When log [ΔE'] is nearer to 0, change in elastic modulus in solder reflow is smaller, meaning excellent solder resist.

<Insulation resistance test>

The volume resistivity of the insulation material having a thickness of about 35 µm obtained in Production Example 1 was measured using a super-insulation meter DSM-8103 and a flat electrode SME-8311 manufactured by Toa Denpa K.K. under conditions of 23°C, 50% RH and am applied voltate of 117.5 V. The results are summarized in Table 1.

Table 1

| | Example | | | | | | | | | | | Comparative example | |
|---|---|---|---|---|---|---|---|---|---|---|---|---|---|
| | 1 | 2 | 3 | 4 | 5 | 6 | 7 | 8 | 9 | 10 | 11 | 1 | 2 |
| Component (A) | | | | | | | | | | | | | |
| A1 | 100 | 100 | 100 | | | 70 | 30 | 100 | 100 | 100 | 100 | 100 | |
| A2 | | | | 100 | | | | | | | | | |
| A3 | | | | | 100 | | | | | | | | |
| A4 | | | | | | 30 | 70 | | | | | | |
| Component (B) | | | | | | | | | | | | | |
| B1 | 5 | 5 | 2 | 2 | 2 | 2 | 2 | 3 | 3 | | | | |
| B2 | | | | | | | | | | 3 | | | |
| B3 | | | | | | | | | | | 3 | | |
| Pigment (C) | | | | | | | | | | | | | |
| C1 | | | | | | | | 0.1 | | | | | |
| SR-320 | | | | | | | | | | | | | 100 |
| Production method of composition | Production example | | | | | | | | | | | | |
| | 1 | 1 | 1 | 1 | 1 | 1 | 1 | 1 | 2 | 2 | 2 | 1 | - |
| Light irradiation period* | BF | AF | AF | AF | AF | AF | AF | AF | AF | AF | AF | without irradia-tion | AF |
| Dose [$mJ/cm^2$] | 400 | 400 | 600 | 600 | 600 | 600 | 600 | 600 | 600 | 600 | 600 | 0 | 800 |
| Solder heat resistance (Ω · cm) | ○ | ○ | ○ | ○ | ○ | ○ | ○ | ○ | ○ | ○ | ○ | × | × |
| Volume resistivity | - | - | - | - | - | - | - | - | $4.24 \times 10^{14}$ | $2.42 \times 10^{14}$ | $2.01 \times 10^{14}$ | - | - |
| log[ΔE'] | -1.15 | - | -0.29 | 0.23 | -0.1 | -0.15 | 0.17 | -1.78 | - | - | - | <-2.14 | N.D. |

[—] indicates no measurement

Light irradiation period* = BF: before heat press, AF: after heat press or application

(Production Example 3 of resin composition for insulation material)

Using a homo-direction twin-screw extruder equipped with a liquid addition apparatus, 100 parts of the component (A), 3 parts of the component (B) and 0.5 parts of the pigment (C2) were melt-kneaded at a temperature of 140°C and a screw rotation of 200 rpm, to obtain pellets. The resulted pellet was extruded through a T die to give a film of about 50 μm which was laminated on a polyethylene terephthalate (PET) film subjected to releasing treatment, to give a two-layer film.

(Examples 12 to 20)

The two-layer film obtained in the above-mentioned Production Example 2 was heat-pressed, under conditions of 180°C, 0.5 MPa and 10 minutes, on a printed wiring board on which a conductor circuit had been previously formed. After peeling the PET film, the laminate was irradiated under conditions shown in Table 2 using an ultraviolet irradiation machine manufactured by Eye Graphics. Then, it was thermally hardened for 1 hours under a temperature shown in Table 2, in a heat oven, to obtain a printed wiring board coated with a solder resist. A part of the resulted wiring board was subjected to a solder heat resistance test directly after molding.
The results are summarized in Table 2.
In Example 17, a wiring board which had not been subjected to a solder heat resistance test was further allowed to absorb moisture under 30°C and 60% RH for 168 hours, then, subjected to a solder heat resistance test, to find no abnormality in film appearance, and no solder submerging.
The PET film was peeled from the two-layer film obtained in the above-mentioned Production Example 2, then, light irradiation and thermal hardening were conducted in the same manner as in Example 17 to obtain an insulation material having a thickness of about 50 μm which was subjected to the same insulation test as described above, to find that the material had an insulation resistivity of $2.3 \times 10^{15}$ Ω · cm, meaning sufficient property as an interlaminar insulation material.

Table 2

| | Example | | | | | | | | |
|---|---|---|---|---|---|---|---|---|---|
| | 12 | 13 | 14 | 15 | 16 | 17 | 18 | 19 | 10 |
| Dose [mJ/cm$^2$]<br>Temperature [°C] | 800<br>110 | 800<br>120 | 800<br>130 | 800<br>140 | 800<br>160 | 800<br>180 | 200<br>180 | 400<br>180 | 600<br>180 |
| Solder heat resistance (initial) | ○ | ○ | ○ | ○ | ○ | ○ | ○ | ○ | ○ |

(Examples 21 to 23, Comparative Example 3

<Production examples of copper foil with resin and printed wiring board containing this copper foil>

Subsequently, the two-layer film obtained in the above-mentioned Production Example 2 and a 18 μm coppper foil JTC 1/20 z manufactured by Nikko Materials K.K. were heat pressed under 0.5 MPa for 5 minutes; to produce a copper foil with resin. Subsequently, using an ultraviolet irradiation machine manufactured by Eye Graphics K.K., light irradiation was effected from above the PET film under conditions shown in Table 3, then, the foil was heat-pressed, under conditions of 180°C, 0.5 MPa and 60 minutes, on a printed wiring board on which a conductor circuit had been previously formed, to form a copper foil layer on the printed wiring board. A part of the resulted printed wiring board was directly subjected to a solder heat resistance test, and the remaining wiring board was allowed to absorb moisture under conditions of 30°C, 60% RH for 168 hours, then, subjected to a solder heat resistance test. The results are summarized in Table 3.

Table 3

| | Example | | | Comparative example |
|---|---|---|---|---|
| | 21 | 22 | 23 | 3 |
| Dose [mJ/cm$^2$] | 100 | 200 | 300 | 0 |
| Solder heat resistance initial<br>after moisture absorption | ○<br>○ | ○<br>○ | ○<br>○ | ×<br>- |

(Examples 24 to 30, Comparative Example 4)

<Production Example of resin composition>

Into Laboplastomill R-100 manufactured by Toyo Seiki Seisakusho K.K. was added components (A) to (B') at ratios shown in Table 4, and melt-kneaded at 120°C for 10 minutes. A part of the resulted resin compositions was subjected to measurement of melt viscosity, and the remaining part was subjected to production of a film having a thickness of about 100 µm by press molding. The melt viscosity was measured in the same manner as described above, and the results are summarized in Table 4.

<Production Example of adhesive>

The film of having a thickness of about 100 µm obtained in the above-mentioned Production Example was heat-pressed on a laminate coated with copper on both surfaces: R-1705 (printed wiring board) manufactured by Matsushita Electric Works, Ltd. under conditions of 180°C, 0.5 MPa and 10 minutes. Subsequently, the laminate was irradiated at a dose of 600 mJ/$cm^2$ using an ultraviolet irradiation machine manufactured by Eye Graphics, to obtain an adhesive in the form of film on the printed wiring board. This wiring board was used as a sample in a solder heat resistance test which was effected under the following conditions. The results are summarized in Table 4.

<Solder heat resistance test>

A printed wiring board coated with an adhesive was immersed in a solder bath of 260°C for 10 seconds using SOLDERABILITY TESTER EST-11 manufactured by Tabai Especk. This was determined as one cycle, and six cycles were repeated, then, the surface appearance was observed.

Evaluation was conducted according to the following criteria.

○: Film appearance shows no abnormality (peeling, swelling), and no solder submerging is manifested
×: Film appearance shows abnormality (peeling, swelling), and solder submerging is manifested

Table 4

| | | Example | | | | | | | Comparative example |
|---|---|---|---|---|---|---|---|---|---|
| | | 24 | 25 | 26 | 27 | 28 | 29 | 30 | 4 |
| Compo-n ent A | A1 | | 50 | | 75 | 50 | 25 | 100 | |
| | A5 | 50 | 25 | 100 | | | | | |
| | A4 | 50 | 25 | | 25 | 50 | 75 | | 100 |
| Component B' : B1 | | 3 | 3 | 3 | 3 | 3 | 3 | 2 | 2 |
| Melt viscosity (Pa · s) | | 150 | 390 | 630 | 440 | 220 | 88 | 740 | 33 |
| Solder heat resistance | | ○ | ○ | ○ | ○ | ○ | ○ | ○ | × |

(Examples 31 to 38, Comparative Examples 5 to 7)

<Production Example of adhesive resin composition and adhesion resin layer [I]>

Using a homo-direction twin-screw extruder equipped with a liquid addition apparatus, 100 parts of the component (A) and 3 parts of the component (B) were melt-kneaded at a temperature of 140°C and a screw rotation of 200 rpm, to obtain pellets. The resulted pellet was processed by a T die to form an adhesion resin layer [I] having a thickness of about 50 µm.

<Supporting substrate layer [II]>

The following layers were used as the supporting substrate layer [II].

II-1:
Polytetrafluoroethylene (thickness: 200 µm)

Nylon Tape TOMBO 9001 manufactured by Nichias Corp.
(no surface treatment)
II-2: Polyethylene terephthalate (thickness: 50 μm)
Dia Foil MRX manufactured by Mitsubishi Chemical
Polyester Film (surface-treated with silicon)
II-3:
Polyethylene terephthalate (thickness: 50 μm)
Dia Foil MRA manufactured by Mitsubishi Chemical
Polyester Film (surface-treated with silicon)
II-4:
Polyethylene teraphthalate (thickness: 50 μm)
Dia Foil MRF manufactured by Mitsubishi Chemical
Polyester Film (surface-treated with silicon)
II-5:
Polyethylene terephthalate (thickness: 50 μm)
Purex G12 manufactured by Teijin DuPont
(surface-treated with silicon)
II-6:
Polyethylene terephthalate (thickness: 38 μm)
Emblet SC-38 manufactured by Unitika, Ltd.
(surface-treated with silicon)
II-7:
Polyethylene terephthalate (thickness: 38 μm)
Emblet FC-38 manufactured by Unitika, Ltd.
(surface-treated with silicon)
II-8:
Polyethylene terephthalate (thickness: 75 μm)
Emblet FF-75 manufactured by Unitika, Ltd.
(surface-treated with silicon)
II-9:
Polyethylene terephthalate (thickness: 50 μm)
Lumilar T-50 manufactured by Toray Corp. (no surface treatment)
II-10:
Polyethylene terephthalate (thickness: 50 μm)
Purex G2Z manufactured by Teijin DuPont
(surface-treated with silicon)
II-11:
Polyethylene terephthalate (thickness: 50 μm)
Purex A-11 manufactured by Teijin DuPont
(surface-treated with silicon)

<Production Example of adhesion sheet>

The above-mentioned adhesion resin layer [I] and a supporting substrate layer [II] described in Table 5 were used and laminated in the order of [II]/[I]/printed wiring board (adhesion body: laminate coated with copper on both surfaces: R-1705, manufactured by Matsushita Electric Works, Ltd.) and heat-pressed under conditions of 180°C, 0.5 MPa and 10 minutes, to obtain an adhesion sheet.
The supporting substrate layer [II] was peeled manually from the resulted adhesion sheet, and releasability evaluation and measurement of contact angle as described below were conducted, and the results are described in Table 5.

<Releasability Evaluation>

Releasing possibility was evaluated from released condition of the supporting substrate layer [II] in manually peeling the supporting substrate layer [II] of the resulted adhesion sheet.

○: releasing is possible (supporting substrate layer [II] is not broken, and adhesion resin layer [I] does not remain)
×: releasing is impossible (supporting substrate layer [II] is broken, and adhesion resin layer [I] remains)

<Measurement of contact angle>

2 μl of water was dropped by a micro syringe on the surface of a supporting substrate layer [II], and the contact angle was measured using a protractor under condition of a magnification of 20 by a video microscope.

Table 5

| | | Supporting substrate layer [II] | Contact angle | Releasability |
|---|---|---|---|---|
| Example | 31 | II-1 | 114° | ○ |
| | 32 | II-2 | 96° | ○ |
| | 33 | II-3 | 102° | ○ |
| | 34 | II-4 | 108° | ○ |
| | 35 | II-5 | 82° | ○ |
| | 36 | II-6 | 108° | ○ |
| | 37 | II-7 | 80° | ○ |
| | 38 | II-8 | 100° | ○ |
| Comparative example | 5 | II-9 | 66° | × |
| | 6 | II-10 | 58° | × |
| | 7 | II-11 | 16° | × |

(Production examples of laminate and adhesion strength of adhesion resin layer [I] in the laminate)

For measuring the adhesion strength between an adhesion resin layer [I] and adhesion body in a laminate, polyethylene terephthalate [II-9] as a flexural adhesion material, the same adhesion resin layer [I] as in the example, and a printed wiring board as a rigid adhesion material (laminate coated with copper on both surfaces: R-1705, manufactured by Matsushita Electric Works, Ltd.) were used and laminated in the order of flexural adhesion material/[I]/rigid adhesion material, and heat-pressed under conditions of 180°C, 0.5 Mpa and 10 minutes, to obtain an adhesion sheet. Subsequently, without peeling the flexural adhesion material from the adhesion sheet, light irradiation was conducted at a dose of 150 $mJ/cm^2$ or 600 $mJ/cm^2$ using an ultraviolet irradiation machine manufactured by Eye Graphics from the flexural adhesion material side, to obtain a laminate for measurement of adhesion strength to which the flexural adhesion material had been adhered. The resulted laminate was cut at a width of 1 cm, and a 180° peeling test was performed according to JIS K6854. As a result, any of them caused peeling between the flexural adhesion material and the adhesion resin layer [I], and showed peeling strength of 8.7 N/cm and 3.3 N/cm, respectively. No peeling occurred between the adhesion resin layer [I] and the rigid adhesion body. Namely, it was clarified that adhesion strength between the adhesion resin layer [I] and the adhesion body in the laminate of the present invention was over 8.7 N/cm and 3.3 N/cm.

## Claims

1. A resin composition for insulation material comprising the following components (A) and (B):

    (A) a copolymer comprising a vinyl group-containing monomer unit [a] and an epoxy group-containing monomer unit [b],
    (B) a polymerization initiator.

2. A resin composition for adhesive comprising the following components (A) and (B'), wherein the composition has a melt viscosity of from 50 to 1000 Pa · s at a temperature of 180°C and a shearing speed of $1.2\times10^2$ $sec^{-1}$:

    (A) a copolymer comprising a vinyl group-containing monomer unit [a] and an epoxy group-containing monomer unit [b],
    (B') a cation polymerization initiator.

3. The composition according to Claim 1 or 2 wherein the component (A) is a copolymer containing an epoxy group-containing monomer unit [b] in an amount of 1 to 150 parts by weight based on 100 parts by weight of a vinyl group-containing monomer unit [a].

**4.** The composition according to Claim 1 or 2 wherein the component (A) is a copolymer further containing an unsaturated ester compound unit [c].

**5.** The composition according to Claim 4 wherein the content of the unsaturated ester compound unit [c] in the component (A) is 250 parts by weight or less based on 100 parts by weight of the vinyl group-containing monomer unit [a].

**6.** The composition according to any one of Claims 1 to 5 wherein the vinyl group-containing monomer unit [a] is a polymerization unit derived from at least one monomer selected from ethylene, $\alpha$-olefin, aromatic vinyl and acrylonitrile.

**7.** The composition according to Claim 6 wherein the vinyl group-containing monomer unit [a] is a polymerization unit derived from ethylene and/or propylene.

**8.** The composition according to any one of Claims 1 to 7 wherein the epoxy group-containing monomer unit [b] is an epoxy group-containing monomer unit of the following general formula (1):

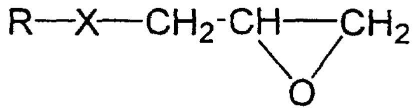

(1)

wherein R represents an alkenyl group having 2 to 18 carbon atoms, and X represents a carbonyloxy group, methyleneoxy group or phenyleneoxy group.

**9.** The composition according to Claim 8 wherein the epoxy group-containing monomer unit [b] is glycidyl acrylate or glycidyl methacrylate.

**10.** The composition according to any one of Claims 1, 3 to 9 wherein the component (B) is a cation polymerization initiator or photo-radical polymerization initiator.

**11.** The composition according to Claim 2 or 10 wherein the cation polymerization initiator or photo-radical polymerization initiator is an onium salt constituted of at least one cation selected from the group consisting of aromatic sulfonium, aromatic iodonium, aromatic diazonium, aromatic ammonium and $\eta^5$-cyclopentadienyl-$\eta^6$-cumenyl-Fe salts and at least one anion selected from the group consisting of $BF_4^-$, $PF_6^-$, $SbF_6^-$ and an anion of the following general formula (2):

$$[BY_4^-] \qquad (2)$$

wherein Y represents a phenyl group having two or more substitutions of fluorine or trifluoromethyl group.

**12.** The composition according to Claim 10 or 11
wherein the cation polymerization initiator or photo-radical polymerization initiator is an onium salt of $PF_6^-$.

**13.** An insulation material obtained by hardening the composition according to any one of Claims 1, 3 to 12.

**14.** An insulation material obtained by light-hardening the composition according to any one of Claims 1, 3 to 12, then, thermally hardening the composition at 110 to 250°C.

**15.** A solder resist, interlaminate insulation material or a resin for copper foil with resin which is the insulation material according to Claim 13 or 14.

**16.** A printed wiring board or a copper foil with resin containing the insulation material according to Claim 13 or 14.

**17.** A method of forming a laser via comprising laser irradiation to form a through hole (via) leading to a conductor

circuit of a printed wiring board, wherein the printed wiring board according to Claim 16 is used.

**18.** An adhesive obtained by light-hardening the composition according to any one of Claims 2 to 9, 11 and 12.

**19.** An electric or electronic part comprising the adhesive according to Claim 18.

**20.** An adhesion sheet comprising [I] an adhesion resin layer containing the following components (A) and (B) and [II] a supporting substrate layer, wherein the layer [I] is laminated on the layer [II] and the surface of the layer [II] in contact with the layer [I] has a contact angle with water of 75° or more:

(A) a copolymer comprising a vinyl group-containing monomer unit [a] and an epoxy group-containing monomer unit [b],
(B) a polymerization initiator.

**21.** The adhesion sheet according to Claim 20 wherein the component (A) is a copolymer containing the vinyl group-containing monomer unit [a] and the epoxy group-containing monomer unit [b], further, an unsaturated ester compound unit [c].

**22.** The adhesion sheet according to Claim 20 or 21 wherein the component (A) is a copolymer containing 1 to 150 parts by weight of the epoxy group-containing monomer unit [b] and 0 to 250 parts by weight of the unsaturated ester compound unit [c] based on 100 parts by weight of the vinyl group-containing monomer unit [a].

**23.** The adhesion sheet according to any one of Claims 20 to 22, wherein the vinyl group-containing monomer unit [a] is at least one monomer unit selected from the group consisting of ethylene, α-olefin, aromatic vinyl monomer and acrylonitrile.

**24.** The adhesion sheet according to Claim 23, wherein the α-olefin is an α-olefin containing an ethylene unit and/or a propylene unit.

**25.** The adhesion sheet according to any one of Claims 20 to 24, wherein the epoxy group-containing monomer unit [b] is an epoxy group-containing monomer unit of the following general formula (1):

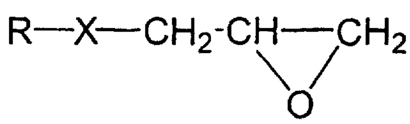

(1)

wherein R represents an alkenyl group having 2 to 18 carbon atoms, and X represents a carbonyloxy group, methyleneoxy group or phenyleneoxy group.

**26.** The adhesion sheet according to any one of Claims 20 to 25 wherein the epoxy group-containing monomer unit [b] is glycidyl acrylate or glycidyl methacrylate.

**27.** The adhesion sheet according to any one of Claims 20 to 26 wherein the component (B) is an onium salt constituted of at least one cation selected from the group consisting of aromatic sulfonium, aromatic iodonium, aromatic diazonium, aromatic ammonium and ferrocenium and at least one anion selected from the group consisting of $BF_4^-$, $PF_6^-$, $SbF_6^-$ and an anion of the following general formula (2):

$$[BY_4^-] \qquad (2)$$

wherein Y represents a phenyl group having two or more substitutions of fluorine or trifluoromethyl group.

**28.** The adhesion sheet according to any one of Claims 20 to 27 wherein the component (B) is an onium salt of $PF_6^-$.

**29.** The adhesion sheet according to any one of Claims 20 to 28 wherein the supporting substrate layer [II] is polytetrafluoroethylene, surface-treated polyester, or surface-treated polyolefin.

**30.** The adhesion sheet according to any one of Claims 20 to 29 wherein the supporting substrate layer [II] is surface-treated polyethylene terephthalate.

**31.** A laminate obtained by adhering the adhesion sheet according to any one of Claims 20 to 30 to an adhesion body, subsequently, peeling the supporting substrate layer [II] from the adhesion sheet, then, hardening the adhesion resin layer.

## INTERNATIONAL SEARCH REPORT

International application No.
PCT/JP01/05483

A. CLASSIFICATION OF SUBJECT MATTER
Int.Cl[7] C08G59/20, C08G59/68, C09J163/00, C09J7/02, H05K3/38, G03F7/027

According to International Patent Classification (IPC) or to both national classification and IPC

B. FIELDS SEARCHED

Minimum documentation searched (classification system followed by classification symbols)
Int.Cl[7] C08G59/20-38, C08G59/68-72, C09J163/00-10, C09J7/02, H05K3/38, G03F7/027

Documentation searched other than minimum documentation to the extent that such documents are included in the fields searched

Electronic data base consulted during the international search (name of data base and, where practicable, search terms used)
WPI/L

C. DOCUMENTS CONSIDERED TO BE RELEVANT

| Category* | Citation of document, with indication, where appropriate, of the relevant passages | Relevant to claim No. |
|---|---|---|
| X | WO 00/00566 A1 (Minnesota Mining and Manufacturing Company), 06 January, 2000 (06.01.00), Claims; page 7, line 26 to page 8, line 25; page 9, lines 17 to 27; page 12, lines 18 to 26 & JP 2000-17242 A Claims; Par. Nos. [0012] to [0014], [0017], [0028] | 1-3,6-13 |
| X | JP 48-93677 A (Sumitomo Chemical Company, Limited), 04 December, 1973 (04.12.73), Claims; working example 1 (Family: none) | 1,3,6-10,13 |
| A | JP 6-33029 A (Daicel Chemical Industries, Ltd.), 08 February, 1994 (08.02.94), Claims (Family: none) | 1-31 |
| A | JP 11-140414 A (Sekisui Chemical Co., Ltd.), 25 May, 1999 (25.05.99), Claims (Family: none) | 1-31 |

☐ Further documents are listed in the continuation of Box C. ☐ See patent family annex.

* Special categories of cited documents:
"A" document defining the general state of the art which is not considered to be of particular relevance
"E" earlier document but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 03 October, 2001 (03.10.01) | 16 October, 2001 (16.10.01) |
| Name and mailing address of the ISA/ Japanese Patent Office | Authorized officer |
| Facsimile No. | Telephone No. |

Form PCT/ISA/210 (second sheet) (July 1992)